# EUROPEAN PATENT APPLICATION

(11) **EP 4 576 187 A1**
(43) Date of publication of application: **25.06.2025**
(21) Application number: 24220539.1
(22) Date of filing: 17.12.2024
(51) Int. Cl.: H01L 21/768, H01L 23/48, H10D 30/47, H10D 62/85

(54) **TRANSISTOR DEVICE BASED ON HETEROSTRUCTURE HAVING A BACK CONTACT REGION AND MANUFACTURING PROCESS THEREOF**

(30) Priority: 22.12.2023 IT 202300027885
(71) Applicant: STMicroelectronics International N.V., 1228 Plan-les-Ouates, Geneva (CH)
(72) Inventor: IUCOLANO, Ferdinando, 95030 GRAVINA DI CATANIA (CT) (IT); LO VERSO, Stella, 95123 CATANIA (IT); TARANTO, Salvatore, 95021 ACI CASTELLO (CT) (IT); TRINGALI, Cristina, 96011 AUGUSTA (SR) (IT)
(74) Representative: Studio Torta S.p.A.

(57) **Abstract**

For manufacturing a device (20) based on heterostructure, a work body (100) is provided having a wafer (130) and an epitaxial multilayer (31) that extends on the wafer along a direction (Z) from a front surface of the wafer up to an upper surface (31A). To form an active area (23), a conduction region (50A) of conductive material is formed on the epitaxial multilayer. To form a contact region (60) for biasing the first conduction region: a front trench (61) is formed in the work body starting from the upper surface (31A) towards the back surface of the wafer, up to a contact surface (65); a conductive region (50B) is formed inside the front trench, on the contact surface, and in electrical contact with the first conduction region; a back trench (62) is formed in the work body starting from the back surface (130B) towards the upper surface up to the contact surface; and a back metallization layer (70) is formed on the back surface of the wafer and inside the back trench, on the contact surface.

## Description

### Technical Field

The present invention relates to a transistor device based on heterostructure, in particular a HEMT ("High Electron Mobility Transistor") device, having a back contact region and to a manufacturing process thereof. In particular, the invention refers to a HEMT device for radio frequency (RF) applications.

### Background

As is known, HEMT devices are heterostructure-based field-effect transistor devices that are finding widespread diffusion thanks to the possibility of operating at high voltages, their high breakdown voltage and a high electron density and mobility.

In particular, HEMT devices for radio frequency applications typically have better RF performance than similar silicon LDMOS devices.

The operation of a heterostructure-based transistor device is based on the formation of a two-dimensional charge carrier (electrons) gas inside a semiconductor heterostructure, at the interface between two different semiconductor materials, generally AlGaN/GaN layers.

Transistor devices have an active area wherein the two-dimensional carrier gas forms a conductive channel between two conduction regions (source region and drain region). Furthermore, the formation of the two-dimensional carrier gas inside the active area is electrostatically modulated by a gate region.

In HEMT devices, the semiconductor heterostructure is grown on a wafer of different material, such as silicon (Si) or silicon carbide (SiC), with respect to the materials forming the heterostructure.

In some HEMT devices, in particular for RF applications, the source region is electrically contacted from the back of the HEMT device.

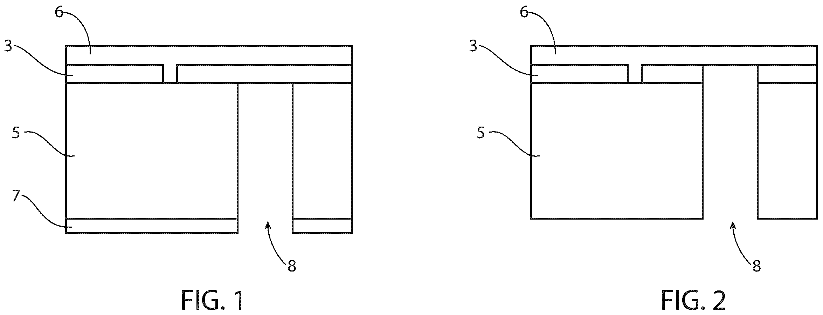

Figure 1 shows an intermediate step of the manufacturing process of a known HEMT device. In Figure 1, a semiconductor heterostructure 3 based on GaN layers has been grown on the front side of a wafer 5 of silicon or silicon carbide. A source metal layer 6 of TiAlCu or gold has been formed on the semiconductor heterostructure 3 and forms the source region.

A back metal layer 7, of nickel or copper, extends on the back side of the wafer 5.

To form the contact via of the source region, a trench 8 is formed from the back of the wafer 5, through the back metal layer 7 and the wafer 5, up to the semiconductor heterostructure 3. The back metal layer 7 is used as a hard mask to form the trench 8.

Subsequently, Figure 2, the portion of the semiconductor heterostructure 3 exposed by the trench 8 is removed, from the back of the wafer 5 and through the trench 8, up to the source metal layer 6.

This approach allows part of the wafer 5 and the semiconductor heterostructure 3 to be removed using a same lithography mask (i.e., the back metal layer 7). However, it has been verified that this approach is difficult to control, due to the low etch selectivity between the GaN that forms the semiconductor heterostructure 3 and the source metal layer 6.

In fact, both the semiconductor heterostructure 3 and the source metal layer 6 are etched using chlorine-based etchant solutions.

Furthermore, this approach makes it difficult both the implementation of post-etch treatments aimed at inhibiting corrosion of the source metal layer 6, in particular when the source metal layer 6 is based on aluminum, and the integration of the HEMT device with other devices, in particular if the integration is done by bonding.

Consequently, this approach entails a low manufacturing process yield and high manufacturing costs.

Furthermore, in known HEMT devices, lattice mismatch between the materials forming the semiconductor heterostructure and the wafer may cause mechanical stress in the wafer. During dicing of the wafer, residual mechanical stress may cause cracks and dislocations to propagate towards the active area of the HEMT device, with a high probability of breakage or malfunctioning of the HEMT device.

According to one approach, an external seal ring and an internal seal ring are formed, in the HEMT device, before dicing the wafer, which surround the active area.

The external seal ring is formed by removing a portion of the semiconductor heterostructure around the active area, throughout the thickness of the semiconductor heterostructure.

The internal seal ring is formed by removing a portion of the dielectric layers formed on the HEMT device, around the active area, between the active area and the external seal ring. The trench formed across the dielectric layers is then filled with a stack of metal layers.

The external seal ring and the internal seal ring reduce the risk of propagation of cracks and dislocations during the dicing of the wafer.

However, the formation of the external seal ring and the internal seal ring require the introduction of additional manufacturing steps, which may lower the yield of the entire manufacturing process and increase its costs.

The aim of the invention is therefore to overcome at least in part the drawbacks of the prior art.

### Summary

According to the present invention, a transistor device based on heterostructure, in particular a HEMT, and a manufacturing process are therefore provided, as defined in the attached claims.

### Brief Description of the Drawings

For a better understanding of the present invention, embodiments thereof are now described, purely by way of nonlimiting example, with reference to the attached drawings, wherein:
- Figures 1 and 2 show cross-sections of a known HEMT device, in subsequent manufacturing steps;
- Figure 3 shows a top-plan view of a HEMT device, according to one embodiment;
- Figure 4A shows a cross-section of a portion of a region of seal rings of the HEMT device of Figure 3, along a section line IVA-IVA of Figure 3;
- Figure 4B shows a cross-section of a portion of an active area of the HEMT device of Figure 3, along a section line IVB-IVB of Figure 3;
- Figures 5A-11A show cross-sections of the HEMT device of Figure 3, along section line IVA-IVA of Figure 3, in subsequent manufacturing steps; and
- Figures 5B-11B show cross-sections of the HEMT device of Figure 3, along section line IVB-IVB of Figure 3, in subsequent manufacturing steps.

### Description of Embodiments

The following description refers to the arrangement shown in the attached Figures; consequently, expressions such as "above", "below", "lower", "upper", "right", "left", "top", "bottom", and similar, relate to the attached Figures and are not to be interpreted in a limiting manner.

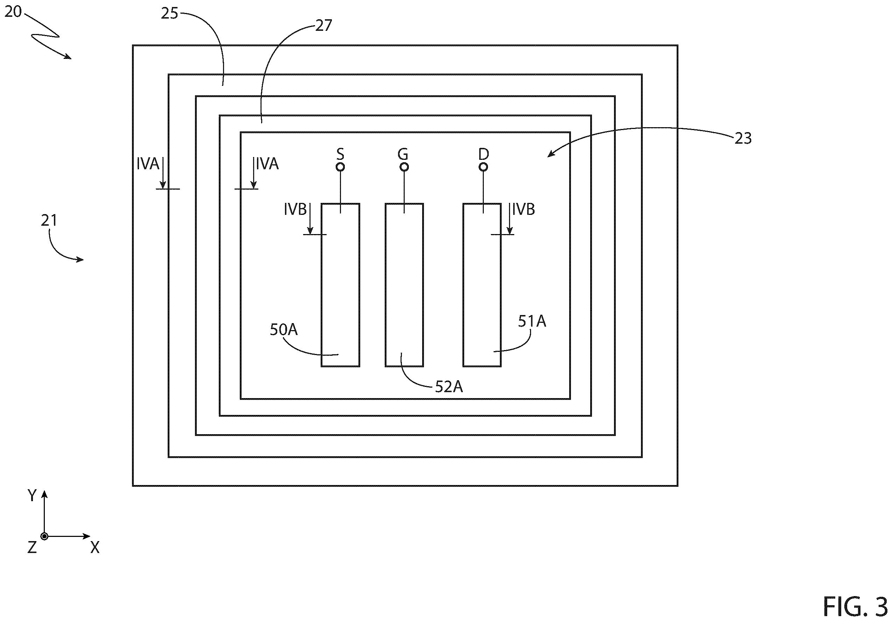

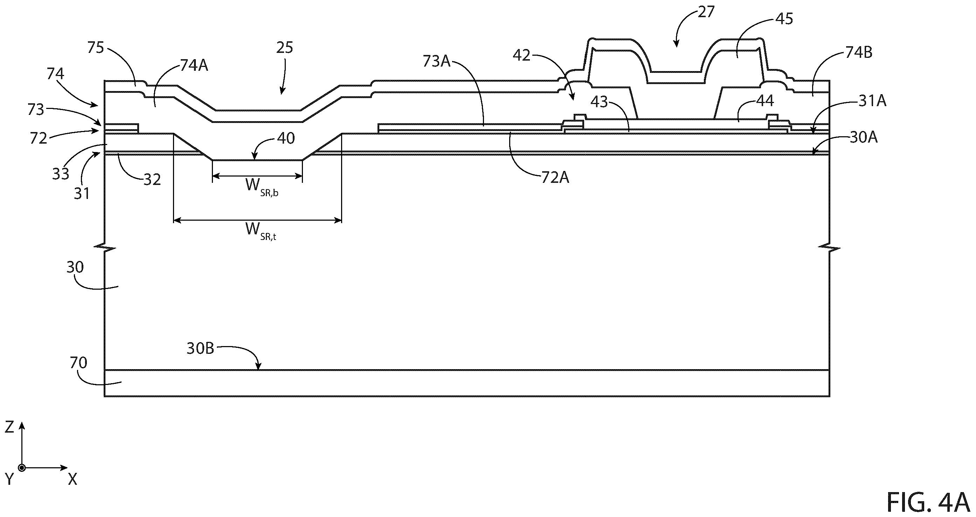

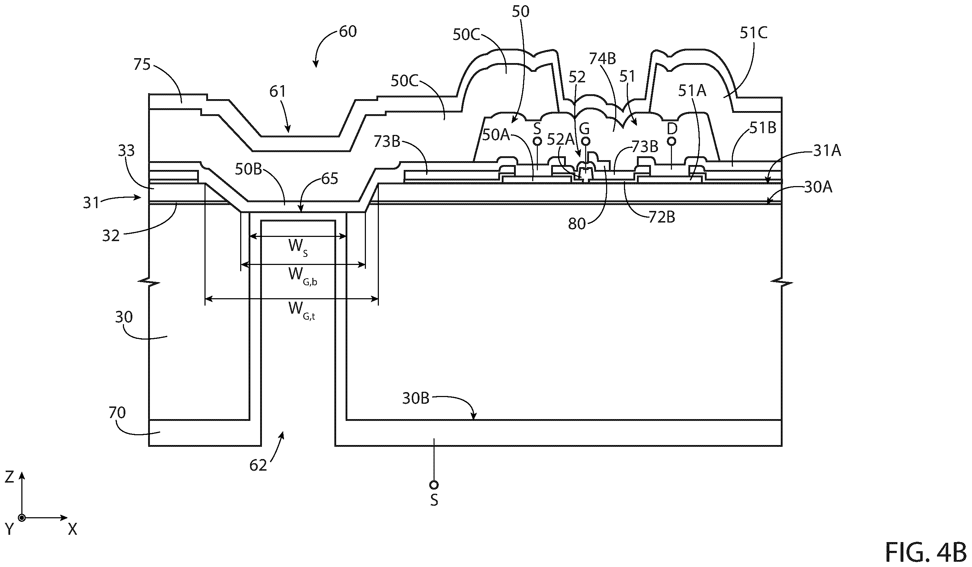

Figures 3, 4A and 4B show a heterostructure-based field-effect transistor device, in particular a HEMT device 20, in a Cartesian reference system XYZ comprising a first axis X, a second axis Y and a third axis Z.

The HEMT device 20 is formed in a die 21 and comprises an active area 23 and an external seal ring 25 which surrounds the active area 23.

In this embodiment, the HEMT device 20 also comprises an internal seal ring 27 which surrounds the active area 23 and is arranged between the active area 23 and the external seal ring 25.

As visible in Figures 4A and 4B, the die 21 comprises a substrate 30 and an epitaxial multilayer 31 extending on the substrate 30.

The substrate 30 may be formed by one or more layers of silicon, silicon carbide, gallium nitride (GaN), sapphire (Al₂O₃) or other materials. In particular, the substrate 30 may be made of semiconductor material, for example silicon or silicon carbide.

The substrate 30 has a front surface 30A and a back surface 30B opposite to each other.

The substrate 30 may have a thickness, measured between the front surface 30A and the back surface 30B along the third axis Z, comprised for example between 40 µm and 120 µm. In particular, for RF applications, the substrate 30 may have a thin thickness, for example comprised between 60 µm and 100 µm.

The epitaxial multilayer 31 extends from the front surface 30A of the substrate 30 up to an upper surface 31A and comprises a buffer region 32 and a semiconductor heterostructure 33.

The epitaxial multilayer 31 may have a thickness, measured between the front surface 30A and the upper surface 31A along the third axis Z, comprised between 1.5 µm and 5 µm.

The buffer region 32, optional, of a different material (for example AlN, AlGaN, GaN, SiC) from that of the substrate 30, extends between the substrate 30 and the semiconductor heterostructure 33 and is useful for allowing an epitaxial growth of the semiconductor heterostructure 33 on the substrate 30.

The semiconductor heterostructure 33 is configured to accommodate a two-dimensional gas of (movable) charge-carriers, in particular of electrons.

In detail, the semiconductor heterostructure 33 comprises two or more compound semiconductor materials, different from each other, including elements from the group III and V of the periodic table.

In particular, the semiconductor heterostructure 33 may be based on GaN, i.e. comprise layers containing GaN, such as for example GaN and alloys comprising GaN.

In detail, although not shown here, the semiconductor heterostructure 33 may comprise a channel layer, for example of gallium nitride (GaN) or an alloy comprising gallium nitride such as InGaN, in particular of GaN; and a barrier layer, for example a compound based on a ternary or quaternary gallium nitride alloy, such as AlₓGa₁₋ₓN, AlInGaN, InₓGa₁₋ₓN, AlₓIn₁₋ₓAl, AlScN, in particular of aluminum gallium nitride (AlGaN), overlying one another.

The semiconductor heterostructure 33 forms the upper surface 31A.

The external seal ring 25 is a trench (hereinafter referred to as external trench 25) that extends, along the third axis Z, through the epitaxial multilayer 31, throughout the thickness of the epitaxial multilayer 31.

In this embodiment, the external seal ring 25 also partially extends inside the substrate 30, up to a lower surface 40. This may allow optimizing the manufacturing of the present HEMT device, and therefore lowering its manufacturing costs.

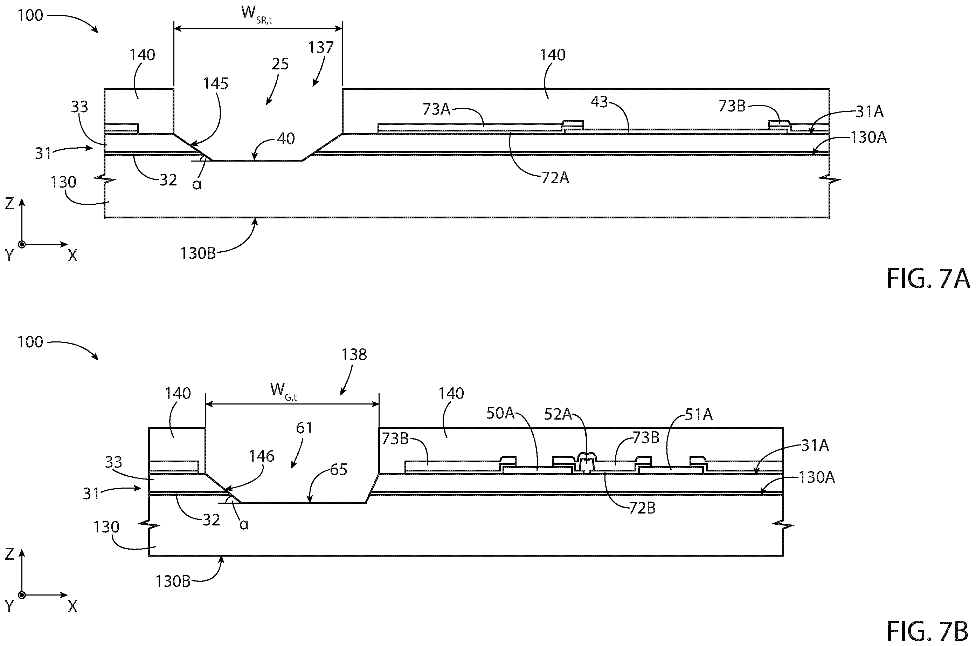

In this embodiment, the width of the external trench 25 (i.e. the width measured along the first axis X in the section of Figure 4A) has a decreasing trend from the upper surface 31A towards the lower surface 40. For example, lateral walls of the external trench 25 may have a slope lower than 60°, as discussed in detail below in reference to Figure 7A.

In detail, the external trench 25 has, at the upper surface 31A of the epitaxial multilayer 31, a width W_{SR,t} comprised for example between 10 µm and 100 µm and, at the lower surface 40, a width W_{SR,b} smaller than the width W_{SR,t} and for example comprised between 5 µm and 95 µm.

The profile (depth and width trend) along the third axis Z of the external trench 25 is indicative of the specific manufacturing process used for the formation of the external trench 25, as discussed below.

The internal seal ring 27 comprises a stack 42 of metal layers extending on the epitaxial multilayer 31, in particular in direct contact therewith on the upper surface 31A.

In this embodiment, the stack 42 comprises a contact region 43, for example of Ti, Ta, Al, AlCu, AlSiCu, Au, Ni and other metal materials, on the epitaxial multilayer 31; an intermediate region 44, for example of Ti, Al, AlCu, AlSiCu, Ni, Au and other metal materials, on the contact region 43; and an upper region 45, for example of Ti, Al, AlCu, AlSiCu, Ni, Au and other metal materials, on the intermediate region 44.

As shown in Figures 3 and 4B, the HEMT device 20 comprises, in the active area 23, a source region 50, a drain region 51 and a gate region 52 which form, respectively, a source electrode S, a drain electrode D and a gate electrode G of the HEMT device 20.

The source region 50 and the drain region 51 extend in contact with the epitaxial multilayer 31 and are each formed by a plurality of conductive layers, in particular metal ones, arranged one on top of the other.

In detail, the source region 50 and the drain region 51 each comprise a respective functional portion 50A, 51A, for example of Ti, Ta, Al, AlCu, AlSiCu, Au, Ni and other metal materials, in electrical contact, in particular in ohmic contact, with the semiconductor heterostructure 33; respective first contact portions 50B, 51B, for example of Ti, Al, AlCu, AlSiCu, Au, Ni and other metal materials, extending on the respective functional portions 50A, 51A; and respective second contact portions 50C, 51C, for example of Ti, Al, AlCu, AlSiCu, Au, Ni and other metal materials, extending on the respective first contact portions 50B, 51B.

The gate region 52 comprises a respective functional portion 52A configured to modulate the formation of the 2DEG in the semiconductor heterostructure 33.

The characteristics of the functional portion 52A depend on the type (normally-on or normally-off type) of the HEMT device 20. For example, the functional portion 52A may be of metal material, in particular to obtain a normally-on device; or of semiconductor material (for example of p-GaN), in particular to obtain a normally-off device.

In particular, in the case of HEMT devices for RF applications, the HEMT device may be of the normally-on type and, for example, the functional portion 52A may be of metal material.

The functional portion 52A extends on the semiconductor heterostructure 33, between the functional portions 50A, 51A of the source region 50 and, respectively, of the drain region 51.

The gate region 52 may be of insulated type, i.e. comprising an insulating region in contact with the semiconductor heterostructure 33.

The gate region 52 further comprises gate contact regions, not shown here, of conductive material (in particular, metal material) in electrical contact with the functional portion 52A for biasing, in use, the gate region 52.

For simplicity, in Figure 3, the respective functional portions 50A, 51A, 52A of the source 50, drain 51 and gate 52 regions are shown.

The HEMT device 20 further comprises a source contact region 60 (Figure 4B) extending in the active area 23, for biasing, in use, the source region 50.

The source contact region 60 comprises a front trench 61 that extends along the third axis Z from the upper surface 31A through the epitaxial multilayer 30, and a back trench 62 that extends along the third axis Z from the back surface 30B of the substrate 30 through the substrate 30 towards the front surface 30A of the substrate 31.

In detail, the front trench 61 extends along the third axis Z up to a contact surface 65 and the back trench 62 extends along the third axis Z up to the contact surface 65.

In practice, the contact surface 65 delimits the front trench 61 at the bottom and the back trench 62 at the top.

In this embodiment, the front trench 61 extends throughout the thickness of the epitaxial multilayer 31 and for part of the thickness of the substrate 30. In other words, the contact surface 65 extends in this embodiment, inside the substrate 30.

In this embodiment, the width of the front trench 61 (i.e. the width measured along the first axis X in the section of Figure 4B) has a decreasing trend from the upper surface 31A up to the contact surface 65. For example, lateral walls of the front trench 61 may have a slope lower than 60°, as discussed in detail below in reference to Figure 7B.

In detail, the front trench 61 has, at the upper surface 31A of the epitaxial multilayer 31, a width W_{G,t} comprised for example between 15 µm and 100 µm and, at the contact surface 65, a width W_{G,b} smaller than the width W_{G,t} and comprised for example between 10 µm and 95 µm.

The profile (depth and width trend) along the third axis Z of the front trench 61 is indicative of the specific manufacturing process used for the formation of the front trench 61, as discussed below.

In particular, according to one embodiment, the external trench 25 and the front trench 61 may have the same profile; this may allow the costs of the manufacturing process to be simplified and lowered.

The back trench 62 has a width W_{S}, measured along the first axis X at the contact surface 65, which is different from the width W_{G,b} of the front trench 61. In particular, in this embodiment, the width W_{S} of the back trench 62 is smaller than the width W_{G,b} of the front trench 61.

This allows good contact between the front trench 61 and the back trench 62 to be ensured.

The width W_{S} may be comprised for example between 8 µm and 93 µm.

The width of the back trench 62, measured along the first axis X, may have, from the back surface 30B towards the contact surface 65, a decreasing or substantially constant trend along the third axis Z, depending on the specific process used for the formation of the back trench 62.

The first and the second contact portions 50B, 50C of the source region 50 extend inside the front trench 61.

In detail, the first contact portion 50B extends on the contact surface 65 and, in particular, also conformally with the lateral walls of the front trench 61. This may ensure that the first contact portion 50B of the source region 50 is continuous between the contact surface 65 and the respective functional portion 50A, and therefore ensure a good electrical connection.

A back metallization region 70 comprising one or more layers, for example Au, Cu, Al, AlCu, AlSiCu and other metal materials, extends on the back side of the die 41.

In detail, the back metallization region 70 extends on the back surface 30B of the substrate 30 and, inside the back trench 62, on the contact surface 65. In particular, the back metallization region 70 may extend conformally on the lateral walls of the back trench 62, so as to obtain a good electrical connection.

In practice, the back metallization region 70 is in contact with the first contact portion 50B of the source region 50, inside the front trench 61.

The back metallization region 70 may thus be used as a contact electrode for biasing the source region 50.

Insulating layers may extend on the front side of the die 41, for example to optimize the electrical performance of the HEMT device 20, for the passivation of the HEMT device 20 and/or for other reasons linked to the manufacturing of the HEMT device 20, for example to be used as growth, deposition and/or etch masks.

A sealing layer 72, for example of aluminum oxide, aluminum nitride, silicon oxide, or silicon nitride, may have portions 72B that extend in the active area 23, i.e., towards the inside of the internal seal ring 27 (Figure 4B), on the upper surface 31A on the sides of the functional portion 52A of the gate region 52, and partially on the contact portion 50A of the source region 50 and on the contact portion 51A of the drain region 51. The sealing layer may also have portions 72A that extend outside the active area 23 (Figure 4A), i.e. externally to the internal seal ring 27, on the upper surface 31A.

An insulating layer 73, for example of silicon nitride or silicon oxide, may have portions 73B that extend, internally to the internal seal ring 27, on the portions 72B of the sealing layer 72 and, externally to the internal seal ring 27, on the portions 72A of the sealing layer 72.

An insulating layer 74, for example of TEOS, silicon oxide or silicon nitride, may have portions 74B that extend on the die 41 internally to the internal seal ring 27, for example in the active area 23 (Figure 4B) over part of the source 50, drain 51 and gate 52 regions; and portions 74A that extend on the die 41 externally to the internal seal ring 27 (Figure 4A), over the insulating layer 73 or directly on the epitaxial multilayer 31.

As visible in Figure 4A, the internal seal ring 27 extends along the third axis Z throughout the entire thickness of the insulating layers 72, 73, 74, up to the upper surface 31A of the epitaxial multilayer 31. In practice, the stack 42 which forms the internal seal ring 27 is an interruption of the insulating layers 72, 73, 74. In other words, the portions 72B, 73B, 74B of the insulating layers 72, 73, 74 which are arranged internally (towards the center of the die 41 in the view of Figure 3) to the internal seal ring 27 are separated by the portions 72A, 73A, 74A of the insulating layers 72, 73, 74 which are arranged externally (towards the external perimeter of the die 41) to the internal seal ring 27.

In detail, the insulating layer 74 may also extend inside the external trench 25 forming the external seal ring 25, in particular conformally on the walls of the trench 25.

A further insulating layer 75, for example of silicon nitride and/or polyimide and polyamide, may extend over the insulating layer 74 and the second contact portions 50C, 51C, for example in such a way as to form an upper passivation layer of the HEMT device 20.

The HEMT device 20 may also comprise a field plate region 80 of conductive material, for example of the same material as the portions 50B, 51B, that extend in the active area 23 over (at a distance from) the upper surface 31, between the source region 50 and the drain region 51. For example, in Figure 4B, the field plate region 80 extends on the insulating layer 73.

The source contact region 60 gives the HEMT device 20 a good electrical connection of the source region 50, in particular for RF applications, and high reliability.

Furthermore, the presence of external and internal seal rings allows the reliability of the HEMT device 20 to be further increased.

Hereinbelow steps of a manufacturing process of the HEMT device 20 are described with reference to the cross-sections of Figures 4A and 4B.

In detail, Figures from 5A to 11A show subsequent manufacturing steps of the portion of the seal ring area shown in Figure 4A, and Figures from 5B to 11B show subsequent manufacturing steps of the portion of the active area 23 shown in Figure 4B.

Consequently, in the description of the manufacturing process, elements common to those already described in reference to Figures 4A and 4B are indicated with the same reference number and are not further described in detail.

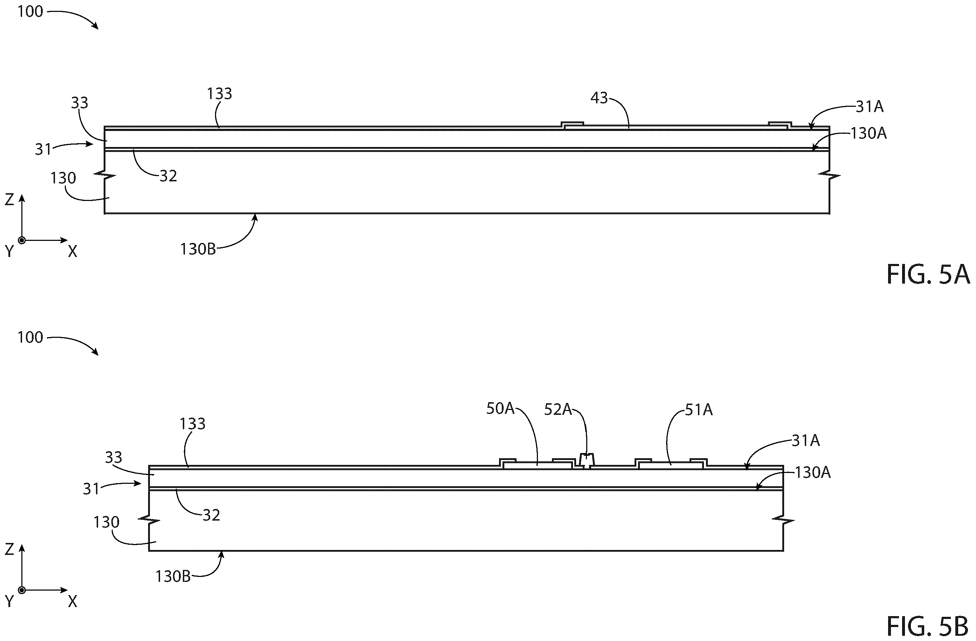

Figures 5A and 5B show a work body 100 comprising a wafer 130, for example formed by one or more layers of silicon, silicon carbide, gallium nitride (GaN), sapphire (Al₂O₃) or other materials. In particular, in this embodiment, the wafer 130 is of semiconductor material, for example silicon or silicon carbide.

The wafer 130 has a front surface 130A and a back surface 130B opposite to each other.

The wafer 130 is intended to form the substrate 30.

The epitaxial multilayer 31 has already been grown on the wafer 130.

Furthermore, the contact region 43 (Figure 5A) and the functional portions 50A, 51A and 52A of the source 50, drain 51 and, respectively, gate 52 regions (Figure 5B) have already been formed on the epitaxial multilayer 31.

In particular, the region 43 and the portions 50A, 51A may be formed starting from a same metal layer, for example through deposition and subsequent selective removal or through masked deposition and lift-off.

Still with reference to Figures 5A and 5B, a work sealing layer 133, for example of aluminum oxide, aluminum nitride, silicon oxide, silicon nitride, intended to form the sealing layer 72, is formed on the front side of the work body 100.

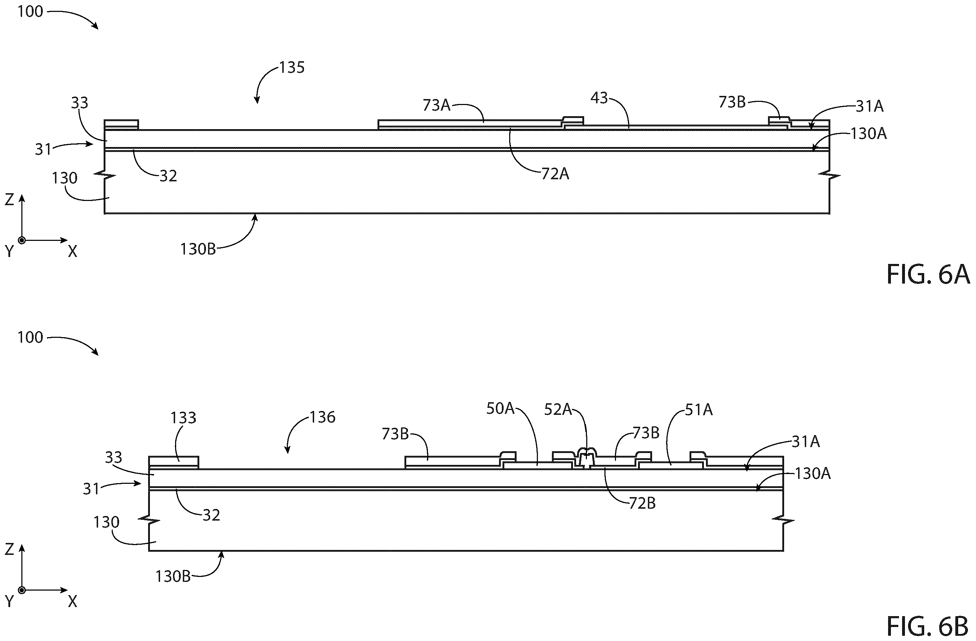

Subsequently, Figures 6A and 6B, the insulating layer 73 is formed on the work sealing layer 133. For example, the insulating layer 73 may be formed through blanket deposition and subsequent masking, lithography and etch steps.

Two openings 135, 136 are formed through the insulating layer 73 and the work sealing layer 133, at the portions of the semiconductor heterostructure 33 where the external trench 25 (Figure 4A) and, respectively, the front trench 61 (Figure 4B) are intended to be formed.

In practice, the openings 135, 136 expose the upper surface 31A of the epitaxial multilayer 31.

Then, Figures 7A and 7B, the external trench 25 is formed inside the opening 135 and the front trench 61 is formed inside the opening 136.

In detail, a mask 140, for example of a material patternable by lithography such as photoresist, is formed on the work body 100. The mask 140 has two windows 137, 138 inside the openings 135 and, respectively, 136.

The window 138 may have, as a first approximation, along the first axis X, the width W_{G,t} described in reference to the front trench 61 (Figure 4B).

The window 137 may have, as a first approximation, along the first axis X, the width W_{SR,t} described in reference to the external trench 25 (Figure 4A).

To form the external trench 25 and the front trench 61, the epitaxial multilayer 31 is removed (etched) inside the windows 137, 138 using an etchant configured to remove the materials that form the epitaxial multilayer 31.

For example, in case the epitaxial multilayer 31 comprises GaN-based materials, the etchant may be a chlorine-based mixture.

In particular, the removal of the epitaxial multilayer 31 may be a plasma-mediated etch in an atmosphere comprising Cl₂, BCl₃ and Ar.

The use of BCl₃ may allow the etch rate and the slope of the lateral walls 145, 146 of the trenches 25, 61 to be controlled. In particular, increasing the BCl₃ concentration allows the etch rate to be decreased and the slope of the lateral walls 145, 146 to be decreased (i.e., it allows to obtain trenches having a greater difference between upper width at the surface 31A and lower width at the surfaces 40, 65) .

The use of Ar allows the etch rate, the selectivity of the etch towards the mask 140 and the profile of the trenches 25, 61 to be controlled. In particular, increasing the Ar concentration allows the selectivity towards the mask 140 to be increased, and the slope of the lateral walls 145, 146 to be increased (i.e., it allows to obtain trenches having a more uniform width along the third axis Z; in other words, it allows a smaller difference between upper width at the surface 31A and lower width at the surfaces 40, 65 to be obtained).

According to one embodiment, the etchant may be adapted in such a way that the lateral walls 145, 146 form, with a direction parallel to the first axis X, an angle α smaller than 60°, in particular comprised between 30° and 60°.

The etch time may be chosen as a function of the thickness of the epitaxial multilayer 31 and the desired thickness of the trenches 25, 61.

For example, the fact that the trenches 25, 61 are formed so that the surfaces 40, 65 extend inside the wafer 130 may ensure a complete removal of the epitaxial multilayer 31, and therefore optimize the manufacturing of the present HEMT device. For example, in case the wafer 130 is of silicon, the portions of the trenches 25, 61 that extend inside the wafer 130 may be formed through the openings 137, 138, with the same etchant used to remove the epitaxial multilayer 31, going over-etch with respect to the etch time required for the removal of the epitaxial multilayer 31. For example, in case the wafer 130 is of silicon carbide, the portions of the trenches 25, 61 that extend inside the wafer 130 may be formed from the back.

The mask 140 is then removed.

In this embodiment, the external trench 25 and the front trench 61 are formed using the same mask 140. This allows to obtain a good uniformity of thickness and width between the external trench 25 and the front trench 61 across the entire die 41 and between different dice obtained by dicing the work body 100.

Furthermore, the fact of using the same etch mask 140 to form the external trench 25 and the front trench 61 allows the external trench 25 and the front trench 61 to be formed at the same time (in other words, with the same etch steps). Consequently, the external trench 25 and the front trench 61 may have the same profile (same depth along the third axis Z and same slope of the lateral walls 145, 146).

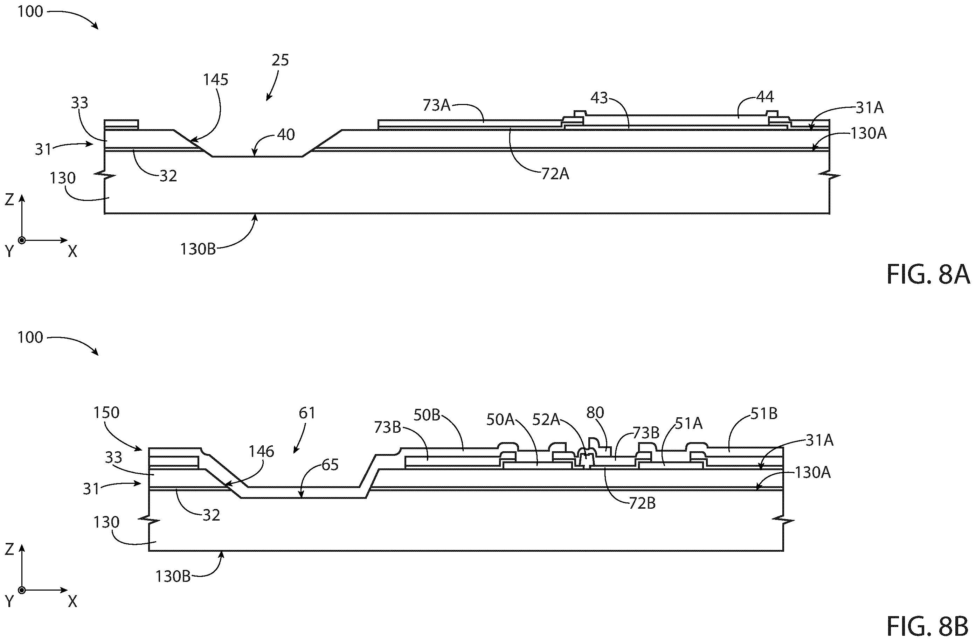

Then, Figures 8A, 8B, a metal layer 150 is deposited and patterned so as to form the intermediate region 44 of the internal seal ring 27, the first contact portions 50B, 51B of the source 50 and drain 51 regions, and, in this embodiment, also the field plate region 80.

A slope lower than 60° of the lateral wall 146 of the front trench 61 may ensure good continuity (conformity) of the metal layer 150 inside the front trench 61, between the contact surface 65 and the functional portion 50A.

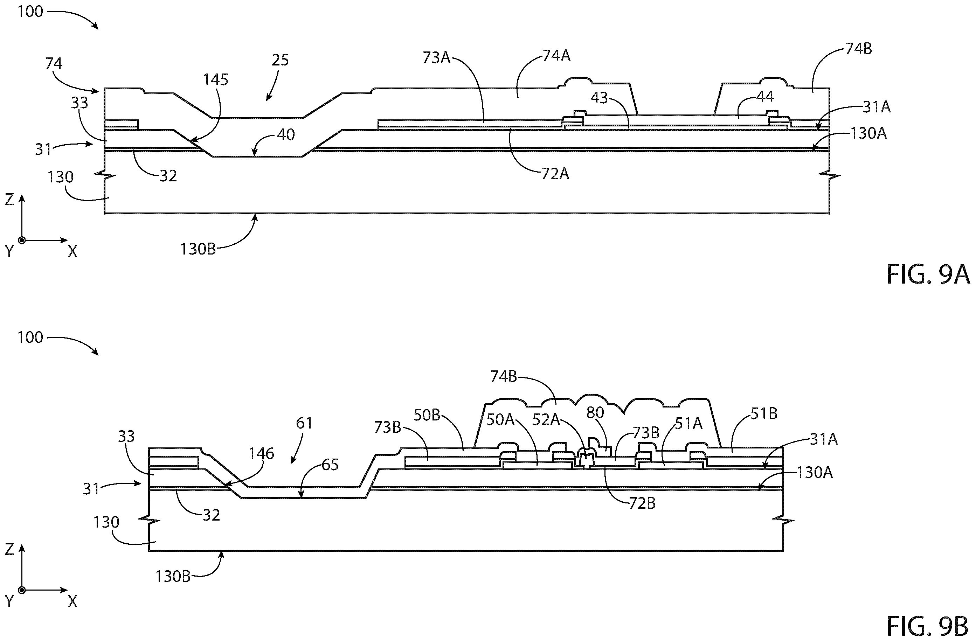

Subsequently, Figures 9A, 9B, the insulating layer 74 is formed on the work body 100, for example through deposition, lithography and etch steps. A slope lower than 60° of the lateral wall 145 of the external trench 25 may ensure good continuity (conformity) of the insulating layer 74 between the lower surface 40 and the upper surface 31A.

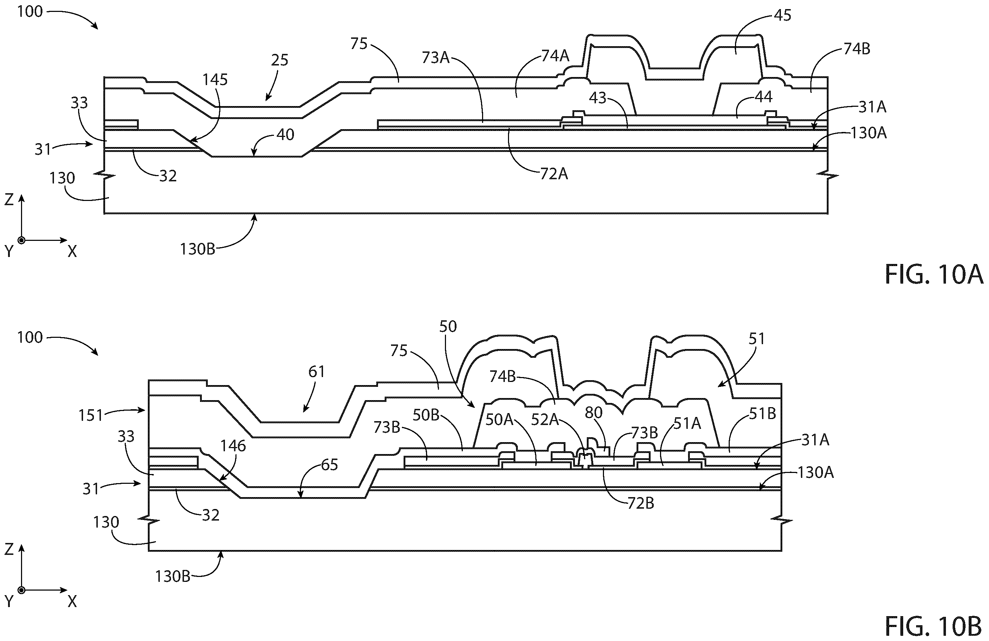

In Figures 10A and 10B, a metal layer 151 is deposited on the work body 100 and patterned, so as to form the upper region 45 of the internal seal ring 27 and the second contact portions 50C, 51C of the source 50 and drain 51 regions.

Still with reference to Figures 10A, 10B, the passivation layer 75 is formed on the front side of the work body 100.

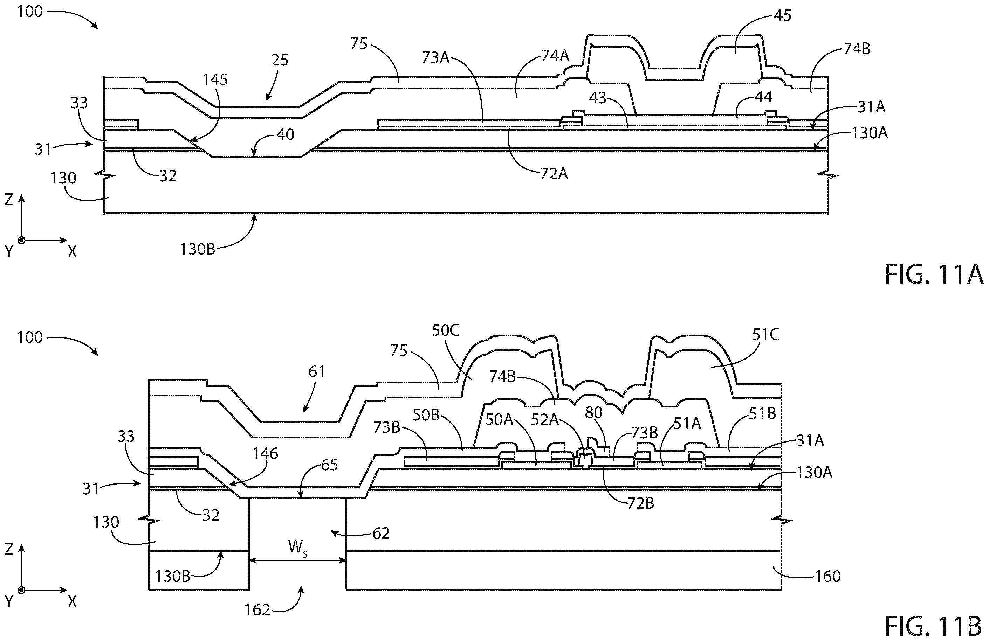

Subsequently, Figures 11A, 11B, the wafer 130 is thinned starting from the back surface 130B, up to obtaining a thickness comprised for example between 40 µm and 120 pm, as previously discussed in reference to the substrate 30. The thinning may be optional. In particular, thinning may be useful in the case the HEMT device 20 is for RF applications.

A mask 160 is formed on the back surface 130B of the wafer. The mask 160 has a window 162 that exposes the portion of the wafer 130 below the contact surface 65.

The width of the window 162 is smaller than the width of the window 138 (Figure 7B).

The back trench 62 is formed by removing the portion of the wafer 130 that is exposed by the mask 160, starting from the back surface 130B and up to the contact surface 65. For example, in case the wafer 130 is of silicon or silicon carbide, a fluorine-based etchant may be used to remove the wafer 130.

The windows 138 and 162 of the masks 140 and, respectively, 160 are not self-aligned with each other. Consequently, the fact that the width of the window 162 (formed after the mask 140) is smaller than the width of the window 138 allows to compensate for possible lithographic misalignments in the formation of the masks 140, 160, to obtain a good alignment between the trenches 61, 62 and thus a good electrical connection between the portion 50B of the source region 50 and the back metallization layer 70.

For example, for thinning the wafer 130 and forming the back trench 62, a temporary support (not shown here) may be bonded to the front side of the work body 100.

Subsequently, in a manner not shown here, the back metallization layer 70 is deposited on the back side of the work body 100, on the back surface 130B and inside the back trench 62.

Finally, final manufacturing steps follow, not shown here and known per se, for example dicing the work body 100 and forming electrical connections, thereby obtaining the HEMT device 20.

The fact that the source contact region 60 is formed by removing the materials that form the epitaxial multilayer 31 from the front side of the work body 100 and the materials that form the wafer 130 from the back side of the work body 100, allows the formation of the front 61 and back 62 trenches to be accurately controlled.

In fact, both the epitaxial multilayer 31 and the wafer 130 may be removed using highly selective etchants, in particular when the semiconductor heterostructure 33 is based on layers containing GaN.

In detail, the etchant used for the removal of the wafer 130, in particular when the wafer 130 is of silicon or silicon carbide, may have a high selectivity with respect to the metal material (in particular if based on aluminum) which forms the first contact portion 50B of the source region 50 inside the front trench 61. The formation of the source contact region 60 may therefore have a low risk of damaging the metal regions inside the front trench 61.

Consequently, the formation of the source contact region 60 may have high yield.

Furthermore, in the embodiment shown, the front trench 61 and the external trench 25 may be formed at the same time, using the same mask 140. This allows to optimize the number of manufacturing steps for forming both the external seal ring 25 and the source contact region 60. Consequently, the HEMT device 20 may have low manufacturing costs and high manufacturing yield.

Finally, it is clear that modifications and variations may be made to the HEMT device and the manufacturing process thereof described and illustrated herein without thereby departing from the scope of the present invention, as defined in the attached claims.

For example, the front trench 61 may be formed after the back trench 62. In this case, the front trench 61 may have a width smaller than the back trench 62.

The external trench 25 and the front trench 61 may be formed using two distinct masks and/or etch steps.

The front trench 61 and the back trench 62 may have, along the second axis Y, a trend that is equal to or different from each other, depending on the specific design layout. For example, the front trench 61 and/or the back trench 62 may extend in the shape of an elongated strip along the second axis Y, or they may have a different shape.

The source contact region 60 may be one of a plurality of source contact regions.

In a different embodiment, the back contact region may be used to contact from the back a different conduction region of the present transistor device, for example the drain region 51 and not the source region 50. In this case, the first contact portion 51B of the drain region 51 may extend inside the front trench 61.

For example, the source and drain regions 50, 51 may have a different number of contact portions, depending on the number of interconnection metal layers of the HEMT device.

The layout in top-plan view of the source, drain, and gate regions may be different from what has been shown in Figure 3, depending on the specific application.

The functional portions 50A, 51A of the source and drain regions 50, 51 may also extend inside the semiconductor heterostructure 33.

The contact surface 65 of the source contact region 60 may not extend also inside the substrate 30; for example, it may extend inside the epitaxial multilayer 31 or at the front surface 30A of the substrate 30.

For example, the internal seal ring 27 and/or the external seal ring 25 may be absent.

Finally, the different embodiments described above may be combined to provide further solutions.

## Claims

1. A process for manufacturing a transistor device (20) based on heterostructure starting from a work body (100), the work body comprising a wafer (130) having a front surface (130A) and a back surface (130B), and an epitaxial multilayer (31) extending on the wafer along a first direction (Z) from the front surface of the wafer up to an upper surface (31A), the manufacturing process comprising:
forming an active area (23) comprising forming a first conduction region (50A) of conductive material on the epitaxial multilayer; and
forming a contact region (60) for biasing the first conduction region,
wherein forming a contact region comprises:
forming a front trench (61) in the work body (100), starting from the upper surface (31A) of the epitaxial multilayer towards the back surface (130B) of the wafer, up to a contact surface (65);
forming a conductive region (50B, 50C) extending inside the front trench (61), on the contact surface (65), and in electrical contact with the first conduction region (50A);
forming a back trench (62) in the work body (100), starting from the back surface (130B) of the wafer (130) towards the upper surface of the epitaxial multilayer, up to the contact surface;
forming a back metallization layer (70) on the back surface of the wafer and inside the back trench, on the contact surface.

2. The manufacturing process according to the preceding claim, wherein forming a front trench comprises forming a first etch mask (140) having a window (138) on the upper surface (31A) of the epitaxial multilayer (31) having a first width (W_{G,t}) along a second direction (X) transversal to the first direction (Z), and wherein forming a back trench (62) comprises forming a second etch mask (160) having a window (162) on the back surface (130B) of the wafer (130) having a second width (W_{S}) along the second direction (X) different from the first width.

3. The manufacturing process according to the preceding claim, wherein the front trench (61) is formed before the back trench (62), the first width being greater than the second width.

4. The manufacturing process according to any of the preceding claims, further comprising forming an external seal ring (25) around the active area (23), wherein forming an external seal ring comprises:
forming an external trench (25) in the work body (100), starting from the upper surface (31A) of the epitaxial multilayer towards the back surface (130B) of the wafer, up to a lower surface (40).

5. The manufacturing process according to the preceding claim, wherein the external trench (25) and the front trench (61) are formed using a same etch mask (140).

6. The manufacturing process according to any of the preceding claims, wherein the front trench (61) extends along the first direction (Z) throughout the thickness of the epitaxial multilayer (31).

7. The manufacturing process according to the preceding claim, wherein the contact surface (65) is arranged inside the wafer (130).

8. The manufacturing process according to any of the preceding claims, wherein the front trench (61) has a width, measured along the second direction (X) transverse to the first direction (Z), decreasing from the upper surface (31A) towards the contact surface (65).

9. The manufacturing process according to any of the preceding claims, wherein the front trench (61) has a lateral wall (146) that forms an angle (α) between the lateral wall and a direction parallel to the second direction (X) transversal to the first direction (Z), the angle being smaller than 60°.

10. The manufacturing process according to any of the preceding claims, wherein the epitaxial multilayer (31) comprises a semiconductor heterostructure (33) based on GaN.

11. The manufacturing process according to any of the preceding claims, wherein the wafer (130) is of semiconductor material, for example silicon or silicon carbide.

12. A transistor device (20) based on heterostructure, comprising:
a die (21) comprising a substrate (30) having a front surface (30A) and a back surface (30B), and an epitaxial multilayer (31) extending on the substrate along a first direction (Z) from the front surface of the substrate up to an upper surface (31A);
an active area (23) comprising a first conduction region (50A) of conductive material on the epitaxial multilayer; and
a contact region (60) for biasing the first conduction region,
wherein the contact region comprises:
a front trench (61) extending in the die (21) from the upper surface (31A) of the epitaxial multilayer towards the back surface (30B) of the substrate, up to a contact surface (65) ;
a conductive region (50B, 50C) extending inside the front trench (61), on the contact surface (65), and in electrical contact with the first conduction region;
a back trench (62) extending in the die (21) from the back surface (30B) of the substrate (30) towards the upper surface of the epitaxial multilayer, up to the contact surface (65); and
a back metallization layer (70) extending on the back surface (30B) of the substrate and inside the back trench, on the contact surface.

13. The device according to the preceding claim, wherein the front trench (61) has, at the upper surface (31A), a first width (W_{G,t}) along a second direction (X) transversal to the first direction (Z), for example comprised between 15 µm and 100 µm, and, at the contact surface (65), a second width (W_{G,b}) along the second direction, for example comprised between 10 µm and 95 pm, smaller than the first width.

14. The device according to claim 12 or 13, further comprising an external seal ring (25) extending around the active area (23) and comprising an external trench extending in the die, from the upper surface (31A) of the epitaxial multilayer towards the back surface (30B) of the substrate (30) up to a lower surface (40), the external trench having a same profile as the front trench (61), for example a same depth and a same slope of the lateral walls.

15. The device according to any of claims 12-14, wherein the device is for radio frequency applications and wherein the substrate has a thickness, along the first direction (Z), comprised between 40 µm and 120 µm.
